# EUROPEAN PATENT APPLICATION

(11) **EP 4 089 720 A1**
(43) Date of publication of application: **16.11.2022**
(21) Application number: 20911506.2
(22) Date of filing: 24.11.2020
(51) Int. Cl.: H01L 21/205, C30B 29/06, C23C 16/02, C23C 16/24

(54) **EPITAXIAL WAFER MANUFACTURING METHOD AND EPITAXIAL WAFER**

(30) Priority: 10.01.2020 JP 2020002741
(71) Applicant: Shin-Etsu Handotai Co., Ltd., Tokyo 100-0004 (JP)
(72) Inventor: SUZUKI, Katsuyoshi, Annaka-shi, Gunma 379-0196 (JP); SUZUKI, Atsushi, Nishishirakawa-gun, Fukushima 961-8061 (JP)
(74) Representative: Wibbelmann, Jobst
(86) International application number: PCT/JP2020/043540
(87) International publication number: WO 2021/140763

(57) **Abstract**

The present invention is a method for manufacturing an epitaxial wafer by forming a single crystal silicon layer on a wafer containing a group IV element including silicon, the method including the steps of: removing a natural oxide film on a surface of the wafer containing the group IV element including silicon in an atmosphere containing hydrogen; forming an oxygen atomic layer by oxidizing the wafer after removing the natural oxide film; and forming a single crystal silicon by epitaxial growth on the surface of the wafer after forming the oxygen atomic layer, where a planar density of oxygen in the oxygen atomic layer is set to 4×10¹⁴ atoms/cm² or less. This provides a method for manufacturing an epitaxial wafer having an epitaxial layer of good-quality single crystal silicon while also allowing the introduction of an oxygen atomic layer in an epitaxial layer stably and simply.

## Description

### TECHNICAL FIELD

The present invention is a technology that relates to: a method for manufacturing an epitaxial wafer; and an epitaxial wafer.

### BACKGROUND ART

Silicon substrates that form semiconductor devices including solid-state image sensors and other transistors are required to have a gettering function against elements including heavy metal that cause the loss or degradation of device characteristics. For gettering, various techniques are proposed and put to practical use, for example: providing a polycrystalline silicon (Poly-Si) layer on a silicon substrate back surface; forming a damaged layer by blasting; using a silicon substrate having a high concentration of boron; and forming a precipitate. In gettering by oxide precipitation, gettering is performed by taking in a metal that has higher ionization tendency (lower electronegativity) than oxygen, which has high electronegativity.

In addition, so-called proximity gettering, in which a gettering layer is formed in the vicinity of an active region of a device, is also proposed. Examples include a substrate having silicon formed by epitaxial growth on a substrate having carbon ion-implanted and so forth. In gettering, the element needs to diffuse to a gettering site (the metal bonds or clusters at the site rather than exists as a single element, so that the energy of the entire system is reduced), and the diffusion coefficient of a metal element contained in silicon varies depending on the element. Moreover, taking into consideration that metal cannot be diffused to gettering sites due to lower process temperatures in recent years, techniques of proximity gettering are proposed.

If oxygen can be used in proximity gettering, it is considered that a silicon substrate having an extremely effective gettering layer can be achieved. In particular, in an epitaxial wafer having an oxygen atomic layer in an epitaxial layer, gettering of metallic impurities can be performed with certainty even in recent low-temperature processes.

In the above, the use of oxygen in proximity gettering has been described regarding mainly the gettering of metallic impurities. As other advantageous effects of oxygen, an effect of preventing auto-doping during epitaxial growth by forming a CVD oxide film on a back surface is known, for example.

Next, preceding technology will be referred to. The method described in Patent Document 1 is a method in which, as the structure, a thin layer of oxygen is formed on silicon, and silicon is further grown. This method is a technique based on ALD ("Atomic layer deposition"). ALD is a method of adsorbing molecules that contain the target atoms and then detaching/desorbing unnecessary atoms (molecules) in the molecules. The method employs surface bonding and is very accurate. In addition, reaction control property is favorable, and the method is widely used.

Patent Document 2 discloses a method of forming a natural oxide film on a silicon clean surface formed by vacuum heating or the like, and then adsorbing and depositing an oxide film or a different substance.

Patent Documents 3 and 4 show that introducing a plurality of oxygen atomic layers into a silicon substrate makes it possible to improve device characteristics (enhance mobility).

Patent Document 5 shows a method of forming an epitaxial layer on an atomic layer having a thickness of 5 nm or less by using an SiH₄ gas. In addition, Patent Document 5 shows a method of providing an oxygen atomic layer as the atomic layer and forming the oxygen atomic layer by using an oxygen gas.

Patent Documents 6 and 7 disclose a method of forming an oxide film by bringing a surface of a semiconductor substrate into contact with oxidizing gas or an oxidizing solution, and then forming a single crystal silicon by epitaxial growth.

An example in Patent Document 6 describes the removal of a natural oxide film by diluted hydrofluoric acid cleaning. In addition, the method of Patent Document 6 describes a method of allowing an oxidizing gas to flow and then allowing a silicon film-forming gas to flow.

Non Patent Document 1 shows a method of removing a natural oxide film by using HF, followed by oxidization in air, then forming a film of amorphous silicon by low pressure CVD, and subsequently forming an epitaxial layer of single crystal silicon by crystallization heat treatment.

### CITATION LIST

### PATENT LITERATURE

Patent Document 1: JP 2014-165494 A
Patent Document 2: JP H05-243266 A
Patent Document 3: US 7,153,763 B2
Patent Document 4: US 7,265,002 B2
Patent Document 5: JP 2019-004050 A
Patent Document 6: JP 2008-263025 A
Patent Document 7: JP 2009-016637 A

### NON PATENT LITERATURE

Non Patent Document 1: I. Mizushima et al., Jpn. J. Appl. Phys. 39(2000)2147.

### SUMMARY OF INVENTION

### TECHNICAL PROBLEM

As described above, methods for the gettering of metallic impurities by forming a layer of oxygen in a wafer have been conventionally used. However, in conventional techniques, while a thin oxygen layer can be obtained with precision, there have been problems that the configuration of an apparatus is complicated, that there are many steps, and so forth.

For example, in the technique disclosed in Patent Document 1, single crystal silicon cannot be formed by epitaxial growth by ALD, so that at least two chambers for ALD and CVD are necessary, and there has been a problem that the configuration of the apparatus is complicated. In addition, since oxidization is performed with ozone, there has been a problem that a special generator for generating ozone is necessary.

Meanwhile, in the technique disclosed in Patent Document 5, there has been a problem that it is necessary to provide two chambers having separate exhaust systems in order to prevent SiH₄ and oxygen from reacting and exploding.

Meanwhile, in the technique disclosed in Patent Document 6, according to the investigation by the inventor, diluted hydrofluoric acid cleaning does not enable sufficient removal of the natural oxide film or oxidization takes place immediately after the removal of the natural oxide film, so that there has been a problem that it is difficult to form single crystal silicon by epitaxial growth stably. Moreover, there has been a problem that a special apparatus that takes safety into consideration is necessary in order to prevent the oxidizing gas and the silicon film-forming gas from reacting and exploding.

In the method disclosed in Non Patent Document 1, a heat treatment needs to be performed at the time of crystallization, and there has been a problem that the number of steps in the process is great. In addition, a large amount of hydrogen is generally contained in amorphous silicon, so that there is a possibility that defects caused by hydrogen may be formed during crystallization heat treatment.

In addition, in conventional technology, there have been problems that there is no description for introducing an oxygen layer stably or specific description for forming an epitaxial layer of good-quality single crystal silicon.

For example, in Patent Document 2, there is no description whatever regarding methods for forming an epitaxial layer of single crystal silicon on a wafer surface without causing dislocation or stacking fault.

Meanwhile, in Patent Documents 3 and 4, there is no mention of specific methods for growing a silicon wafer having a plurality of oxygen atomic layers introduced.

Meanwhile, in Patent Documents 6 and 7, there is no description of methods for removing a natural oxide film before bringing into contact with oxidizing gas or an oxidizing solution.

As described above, in conventional techniques, while a thin layer of oxygen can be obtained with precision, there have been problems that the configuration of the apparatus is complex, that the introduction of the oxygen layer is not stable, that an epitaxial layer of single crystal silicon having good quality cannot be obtained, and so forth. Therefore, a method for manufacturing an epitaxial wafer according to which an oxygen atomic layer can be introduced into an epitaxial layer stably and simply is needed.

The present invention has been made in view of the above-described problems of conventional techniques. An object of the present invention is to provide a method for manufacturing an epitaxial wafer and an epitaxial wafer having an epitaxial layer of good-quality single crystal silicon while also allowing the introduction of an oxygen atomic layer in an epitaxial layer stably and simply.

### SOLUTION TO PROBLEM

To achieve the object, the present invention provides a method for manufacturing an epitaxial wafer by forming a single crystal silicon layer on a wafer comprising a group IV element including silicon, the method comprising the steps of:
removing a natural oxide film on a surface of the wafer comprising the group IV element including silicon in an atmosphere containing hydrogen;
forming an oxygen atomic layer by oxidizing the wafer after removing the natural oxide film; and
forming a single crystal silicon by epitaxial growth on the surface of the wafer after forming the oxygen atomic layer, wherein
a planar density of oxygen in the oxygen atomic layer is set to 4×10¹⁴ atoms/cm² or less.

According to such a method for manufacturing an epitaxial wafer, it is possible to form single crystal silicon on a wafer simply and without forming dislocation or stacking fault on the oxygen atomic layer.

In this event, a single crystal silicon wafer is preferably used as the wafer comprising the group IV element including silicon.

Such a method for manufacturing an epitaxial wafer has higher versatility.

In this event, the natural oxide film is preferably removed by heating the wafer in the atmosphere containing hydrogen in the step of removing the natural oxide film.

When the natural oxide film is removed in this manner, the natural oxide film can be removed more effectively.

In this event, the natural oxide film is preferably removed by heating the wafer to a temperature in a range of 800°C or higher and 1250°C or lower and maintaining the temperature within the range for 1 second or more and 5 minutes or less in the step of removing the natural oxide film.

When temperature range and time are set thus in the step of removing the natural oxide film, the natural oxide film can be removed more stably.

In this event, the natural oxide film is preferably removed by using plasma containing hydrogen in the step of removing the natural oxide film.

When the natural oxide film is removed in this manner, the natural oxide film can be removed more effectively.

In this event, the wafer is preferably oxidized in an atmosphere containing oxygen in the step of forming the oxygen atomic layer.

By providing such an environment in the step of forming the oxygen atomic layer, the wafer can be oxidized more easily without providing special facilities.

In this event, the wafer is preferably oxidized in air in the step of forming the oxygen atomic layer.

By providing such an environment in the step of forming the oxygen atomic layer, the wafer can be oxidized more easily without providing special facilities.

In this event, the epitaxial growth is preferably performed at a temperature of 450°C or higher and 800°C or lower in the step of forming the single crystal silicon by epitaxial growth.

When such a temperature range is set in the step of forming the single crystal silicon by epitaxial growth, the epitaxial growth can be performed more stably and without defects being generated.

In this event, the step of forming the oxygen atomic layer by oxidizing the wafer and the step of forming the single crystal silicon by epitaxial growth are preferably performed alternately multiple times.

By providing a plurality of oxygen atomic layers in this manner, the gettering effect can be further enhanced compared with a case where there is one oxygen atomic layer.

In addition, the present invention provides an epitaxial wafer comprising a single crystal silicon layer on a wafer comprising a group IV element including silicon, the epitaxial wafer comprising
an oxygen atomic layer between the single crystal silicon layer and the wafer comprising the group IV element including silicon, wherein
a planar density of oxygen in the oxygen atomic layer is 4×10¹⁴ atoms/cm² or less.

Such a wafer can have an extremely effective gettering layer in the vicinity of a device region. Therefore, the gettering of metallic impurities can be carried out with certainty even in low-temperature processes of recent years. Furthermore, the epitaxial wafer has an epitaxial layer of good-quality single crystal silicon.

### ADVANTAGEOUS EFFECTS OF INVENTION

As described above, according to the inventive method for manufacturing an epitaxial wafer, it is possible to introduce an oxygen atomic layer near an epitaxial layer stably and simply. In addition, it is possible to provide a proximity gettering substrate that has a proximity gettering effect owing to the oxygen atomic layer and that has an epitaxial layer of single crystal silicon having good quality.

### BRIEF DESCRIPTION OF DRAWINGS

FIG. 1-A is a diagram showing the inventive epitaxial wafer.
FIG. 1-B is a diagram showing the inventive epitaxial wafer having a plurality of oxygen atomic layers and single crystal silicon layers stacked alternately on a wafer.
FIG. 2 is a diagram showing a flow of the inventive method for manufacturing an epitaxial wafer.
FIG. 3 is a figure showing transmission electron microscope images of cross sections of the silicon substrates in Example 1 and Comparative Example 1.
FIG. 4 is a figure showing transmission electron microscope images of a cross section of the silicon substrate in Comparative Example 2.

### DESCRIPTION OF EMBODIMENTS

Hereinafter, the present invention will be described in detail, but the present invention is not limited thereto.

As described above, there have been desired a method for manufacturing an epitaxial wafer and an epitaxial wafer according to which no special apparatuses or complicated processes are needed, and that have an oxygen atomic layer introduced into an epitaxial layer stably, while also having an epitaxial layer of good-quality single crystal silicon.

The present inventors have earnestly studied the above-described problem and found out that it is possible to introduce an oxygen atomic layer to an epitaxial layer stably and simply without forming dislocation or stacking fault in the epitaxial layer on the oxygen atomic layer according to a method for manufacturing an epitaxial wafer by forming a single crystal silicon layer on a wafer containing a group IV element including silicon, the method including the steps of: removing a natural oxide film on a surface of the wafer containing the group IV element including silicon in an atmosphere containing hydrogen; forming an oxygen atomic layer by oxidizing the wafer after removing the natural oxide film; and forming a single crystal silicon by epitaxial growth on the surface of the wafer after forming the oxygen atomic layer, where a planar density of oxygen in the oxygen atomic layer is set to 4×10¹⁴ atoms/cm² or less. Thus, the present invention has been completed.

In addition, the present inventors have found out that an epitaxial wafer including a single crystal silicon layer on a wafer containing a group IV element including silicon, the epitaxial wafer including an oxygen atomic layer between the single crystal silicon layer and the wafer containing the group IV element including silicon, where a planar density of oxygen in the oxygen atomic layer is 4×10¹⁴ atoms/cm² or less has an extremely effective gettering layer in the vicinity of a device region, so that the gettering of metallic impurities can be carried out with certainty even in low-temperature processes of recent years. In addition, the present inventors have found out that such an epitaxial wafer has an epitaxial layer of good-quality single crystal silicon. Thus, the present invention has been completed.

Hereinafter, a description will be given with reference to the drawings.

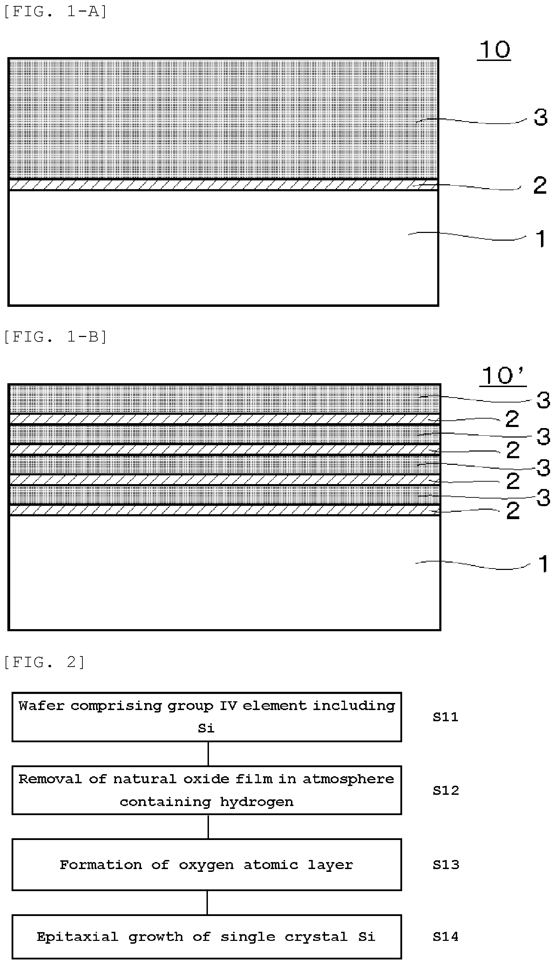

FIG. 1-A is a diagram showing the inventive epitaxial wafer. The inventive epitaxial wafer 10 has a single crystal silicon layer 3 on a wafer 1 containing a group IV element including silicon, and has an oxygen atomic layer 2 between the single crystal silicon layer 3 and the wafer 1 containing the group IV element including silicon.

Here, the planar density of the oxygen in the oxygen atomic layer 2 that the inventive epitaxial wafer 10 has is 4×10¹⁴ atoms/cm² or less. An epitaxial wafer having such a range has low stacking fault of the epitaxial layer of the single crystal silicon. Note that there is no lower limit to the planar density of the oxygen, and the planar density can be greater than 0.

In the present invention, there are no particular limitations as long as the wafer is a wafer 1 containing a group IV element including silicon, and for example, single crystal silicon, SiGe, or SiGeC may be used.

Here, the wafer 1 may be manufactured in any manner. For example, a wafer manufactured by a Czochralski method (hereinafter, referred to as a CZ method) may be used, or a wafer manufactured by a floating zone method (hereinafter, referred to as an FZ method) may be used. Alternatively, it is also possible to use a wafer having a group IV element including silicon formed by epitaxial growth on a single crystal silicon wafer manufactured by a CZ method or an FZ method.

Meanwhile, FIG. 1-B is a diagram showing the inventive epitaxial wafer having a plurality of oxygen atomic layers and single crystal silicon layers stacked alternately on a wafer. As shown in FIG. 1-B, the present invention may have an oxygen atomic layer 2 and a single crystal silicon layer 3 alternately stacked repeatedly on a wafer 1 containing a group IV element including silicon. In this event, the uppermost surface is a single crystal silicon layer.

Here, the planar density of the oxygen in the oxygen atomic layer can be measured by SIMS (Secondary Ion Mass Spectrometry). When Si including an oxide layer is measured by SIMS, a peak is formed at the depth where the Si oxide layer is formed. The planar density of the oxygen can be determined by adding up the product of a volume density in one sputtering and the depth near a peak.

FIG. 2 is a diagram showing a flow of the inventive method for manufacturing an epitaxial wafer. S11 shows a step of providing a wafer containing a group IV element including silicon, S12 shows a step of removing a natural oxide film in an atmosphere containing hydrogen, S13 shows a step of forming an oxygen atomic layer, and S14 shows a step of forming a single crystal silicon by epitaxial growth, respectively.

In the present invention, for example, single crystal silicon, SiGe, or SiGeC can be used as the wafer containing a group IV element including silicon.

Here, the method for manufacturing the wafer is not particularly limited. A wafer manufactured by a CZ method may be used, or a wafer manufactured by an FZ method may be used. Alternatively, it is also possible to use a wafer having a group IV element including silicon formed by epitaxial growth on a single crystal silicon wafer manufactured by a CZ method or an FZ method.

In particular, a single crystal silicon wafer is preferably used as the wafer containing a group IV element including silicon.

When a single crystal silicon wafer is used as the wafer containing a group IV element including silicon as described, versatility is enhanced. In this event, a wafer subjected to ion implantation and a heat treatment may be used as the silicon wafer.

The step S12 of removing a natural oxide film in an atmosphere containing hydrogen according to the present invention is a step of removing a natural oxide film in a reducing dry process including hydrogen. According to studies by the present inventors, the removal of the natural oxide film is not sufficient or oxidization takes place immediately after the removal of the natural oxide film in conventional wet processes with HF, BHF, etc., and therefore, a single crystal silicon cannot be formed by epitaxial growth with stability.

In the step of removing the natural oxide film, the natural oxide film is preferably removed by heating the wafer in the atmosphere containing hydrogen, and furthermore, the natural oxide film is more preferably removed by heating the wafer to a temperature in a range of 800°C or higher and 1250°C or lower and maintaining the temperature within the range for 1 second or more and 5 minutes or less.

In this manner, the natural oxide film can be removed more stably.

Furthermore, in the step of removing the natural oxide film, it is also preferable to remove the natural oxide film by using plasma containing hydrogen.

When the natural oxide film is removed by using plasma containing hydrogen as described, the natural oxide film can be removed at a lower temperature than when the natural oxide film is removed by heating in an atmosphere containing hydrogen. Therefore, this is effective particularly when Ge and Sn, having low heat resistance, are contained in the wafer. For example, in the case of SiGe, the higher the proportion of Ge, the lower the heat-resistance temperature.

Note that when the natural oxide film is removed by using plasma containing hydrogen, the wafer may have the natural oxide film removed at room temperature, or may have the natural oxide film removed while heating.

In the step S13 of forming an oxygen atomic layer, the planar density of the oxygen in the oxygen atomic layer is set to 4×10¹⁴ atoms/cm² or less. When the planar density is set within such a range, defects are not formed in the epitaxial layer. This is because crystallinity of the substrate is maintained when the oxidized amount (the planar density of the oxygen in the oxygen atomic layer) is small. Accordingly, there is no lower limit to the planar density of the oxygen, and the planar density can be greater than 0. If the oxidized amount is large, the epitaxial layer is a polycrystalline silicon or an amorphous silicon. According to investigations of the present inventors, if the planar density of the oxygen in the oxygen atomic layer exceeds 4×10¹⁴ atoms/cm², defects are formed or amorphous silicon is formed.

There are several methods for oxidizing a wafer, and in the present invention, for example, the time to expose the wafer to the atmosphere containing oxygen can be adjusted to form an oxygen atomic layer having the desired planar density of oxygen.

In the step of forming the oxygen atomic layer, the wafer is preferably oxidized in an atmosphere containing oxygen.

When the wafer is oxidized in such an environment, there is no need to provide special facilities, and the wafer can be oxidized easily. In addition, the oxidization may be performed in an atmosphere having an oxygen concentration of 100%, or the oxidization may be performed in an atmosphere having an inert gas such as nitrogen, argon, helium, neon, krypton, and xenon mixed with oxygen. When an inert gas and oxygen are mixed, the atmosphere can be handled safely. Furthermore, the oxidization of the wafer may be performed at room temperature, or may be performed while heating.

In this case, the wafer is preferably oxidized in the air.

When the step of forming the oxygen atomic layer is carried out in such an environment, the oxidization can be performed easily without providing a facility for supplying an atmosphere containing oxygen.

In the step S14 of forming the single crystal silicon by epitaxial growth, monosilane and disilane can be used, for example, as a gas used for the epitaxial growth of the single crystal silicon. Nitrogen and hydrogen may be used as a carrier gas. In addition, the pressure in the chamber can be a pressure at which a gas phase reaction does not occur.

In the step of forming the single crystal silicon by epitaxial growth, the epitaxial growth is preferably performed at a temperature of 450°C or higher and 800°C or lower.

When such a temperature range is applied in the step of forming the single crystal silicon by epitaxial growth, dislocation and stacking fault can be prevented more effectively from being formed in the epitaxial layer. Since the higher the temperature, the higher the epitaxial growth rate, a thick epitaxial layer can be formed in a short time by forming the film at a high temperature. On the other hand, when it is desired to form a thin epitaxial layer, the film can be formed at a low temperature. In this manner, an epitaxial layer having the target thickness can be obtained easily by changing the growth temperature. In addition, when Ge and Sn, which have low heat resistance, are contained in the wafer, the film is desirably formed at a low temperature in order to prevent crystallinity from being degraded.

In addition, as an epitaxial growth apparatus, a batch processing apparatus may be used, or a single wafer processing apparatus may be used.

Furthermore, the step of forming the oxygen atomic layer by oxidizing the wafer and the step of forming the single crystal silicon by epitaxial growth can also be performed alternately multiple times.

When a plurality of oxygen atomic layers are provided as described, the gettering effect can be enhanced compared with when there is only one oxygen atomic layer.

As described above, according to the inventive method for manufacturing an epitaxial wafer, it is possible to introduce an oxygen atomic layer near an epitaxial layer stably and simply. Furthermore, the epitaxial wafer has an epitaxial layer of good-quality single crystal silicon.

### EXAMPLE

Hereinafter, the present invention will be described in detail with reference to an Example, but the present invention is not limited thereto.

### (Example 1)

Single crystal silicon wafers each having the following conductivity type, diameter, and crystal plane orientation were prepared.

| | |
|---|---|
| Conductivity type of substrate | : p type |
| Diameter | : 300 mm |
| Crystal plane orientation | : (100) |

Hydrogen baking was performed in order to remove the natural oxide film of the prepared single crystal silicon wafer. The temperature was set to 1000°C, and the time was set to 1 minute. After that, the wafer was left to stand in the air for 4 hours to 6 hours to form an oxygen atomic layer.

Next, a single crystal silicon was formed by epitaxial growth at a temperature of 580°C on a surface of the single crystal silicon wafer having the oxygen atomic layer formed in the air.

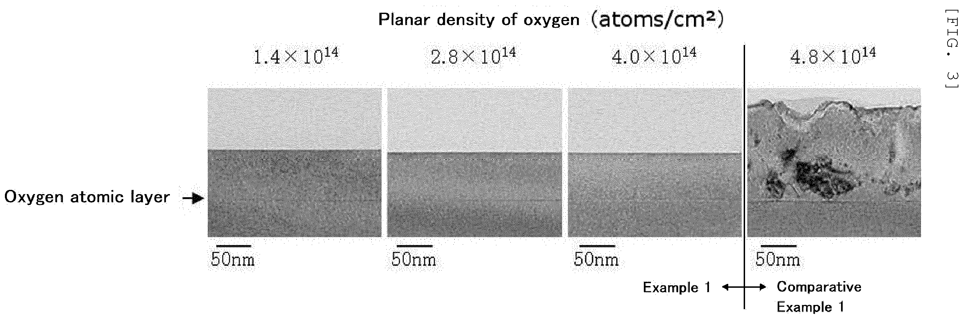

The planar density of oxygen in the oxygen atomic layer of the wafer subjected to epitaxial growth was measured by SIMS, and in order to evaluate crystallinity, cross-sectional TEM (Transmission Electron Microscopy) observation was performed. FIG. 3 shows the observation results. As shown in FIG. 3, in cases where the planar density of the oxygen in the oxygen atomic layer was 1.4×10¹⁴ atoms/cm², 2.8×10¹⁴ atoms/cm², and 4.0×10¹⁴ atoms/cm², that is, 4×10¹⁴ atoms/cm² or less, the single crystal silicon layer was formed without dislocation or stacking fault being formed in the epitaxial layer.

### (Comparative Example 1)

The production and evaluation of an epitaxial wafer were performed under the same conditions as in Example 1 except that in the formation of the oxygen atomic layer, the time that the wafer was left to stand in the air was set to 7 hours.

As shown in FIG. 3, in the case where the planar density of the oxygen in the oxygen atomic layer was 4.8×10¹⁴ atoms/cm², that is, greater than 4×10¹⁴ atoms/cm², defects were formed.

### (Comparative Example 2)

The same single crystal silicon wafer as those in Example 1 and Comparative Example 1 was prepared. After removing the natural oxide film by a wet process by HF cleaning, the wafer was left to stand in the air for 5 hours to form an oxygen atomic layer. Next, epitaxial growth was performed on a surface of the single crystal silicon wafer at a temperature of 580°C.

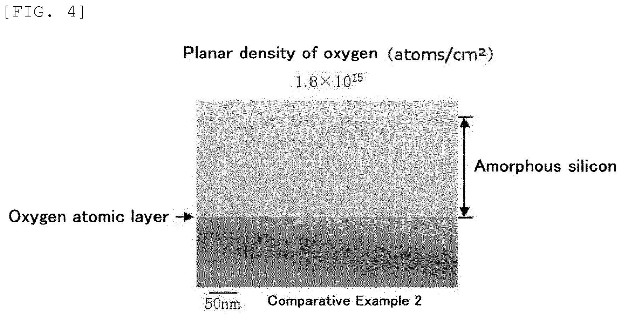

The planar density of oxygen in the oxygen atomic layer of the wafer subjected to epitaxial growth was measured by SIMS, and in order to evaluate crystallinity, cross-sectional TEM observation was performed. FIG. 4 shows the observation results. The planar density of the oxygen in the oxygen atomic layer was 1.8×10¹⁵ atoms/cm², and as shown in FIG. 4, on the oxygen atomic layer, a film of amorphous silicon was formed instead of single crystal silicon, and it was not possible to form a single crystal silicon. Note that if a heat treatment is performed on such a wafer after film formation, polysilicon is formed.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing an epitaxial wafer by forming a single crystal silicon layer on a wafer comprising a group IV element including silicon, the method comprising the steps of:
removing a natural oxide film on a surface of the wafer comprising the group IV element including silicon in an atmosphere containing hydrogen;
forming an oxygen atomic layer by oxidizing the wafer after removing the natural oxide film; and
forming a single crystal silicon by epitaxial growth on the surface of the wafer after forming the oxygen atomic layer, wherein
a planar density of oxygen in the oxygen atomic layer is set to 4×10¹⁴ atoms/cm² or less.

2. The method for manufacturing an epitaxial wafer according to claim 1, wherein a single crystal silicon wafer is used as the wafer comprising the group IV element including silicon.

3. The method for manufacturing an epitaxial wafer according to claim 1 or 2, wherein the natural oxide film is removed by heating the wafer in the atmosphere containing hydrogen in the step of removing the natural oxide film.

4. The method for manufacturing an epitaxial wafer according to claim 3, wherein the natural oxide film is removed by heating the wafer to a temperature in a range of 800°C or higher and 1250°C or lower and maintaining the temperature within the range for 1 second or more and 5 minutes or less in the step of removing the natural oxide film.

5. The method for manufacturing an epitaxial wafer according to claim 1 or 2, wherein the natural oxide film is removed by using plasma containing hydrogen in the step of removing the natural oxide film.

6. The method for manufacturing an epitaxial wafer according to any one of claims 1 to 5, wherein the wafer is oxidized in an atmosphere containing oxygen in the step of forming the oxygen atomic layer.

7. The method for manufacturing an epitaxial wafer according to any one of claims 1 to 6, wherein the wafer is oxidized in air in the step of forming the oxygen atomic layer.

8. The method for manufacturing an epitaxial wafer according to any one of claims 1 to 7, wherein the epitaxial growth is performed at a temperature of 450°C or higher and 800°C or lower in the step of forming the single crystal silicon by epitaxial growth.

9. The method for manufacturing an epitaxial wafer according to any one of claims 1 to 8, wherein the step of forming the oxygen atomic layer by oxidizing the wafer and the step of forming the single crystal silicon by epitaxial growth are performed alternately multiple times.

10. An epitaxial wafer comprising a single crystal silicon layer on a wafer comprising a group IV element including silicon, the epitaxial wafer comprising
an oxygen atomic layer between the single crystal silicon layer and the wafer comprising the group IV element including silicon, wherein
a planar density of oxygen in the oxygen atomic layer is 4×10¹⁴ atoms/cm² or less.
